# EUROPEAN PATENT APPLICATION

(11) **EP 3 503 218 A1**
(43) Date of publication of application: **26.06.2019**
(21) Application number: 18183599.2
(22) Date of filing: 16.07.2018
(51) Int. Cl.: H01L 31/18, H01L 21/67, B23K 26/064, B23K 26/082, B23K 26/362, G02B 26/00, H01L 31/0463, B23K 26/08, G02B 26/10, B23K 26/04

(54) **METHOD AND DEVICE FOR FILM REMOVING PROCESS**

(30) Priority: 19.12.2017 CN 201711377087
(71) Applicant: Beijing Juntai Innovation Technology Co., Ltd, 100176 Beijing (CN)
(72) Inventor: Huang, Tongyang, Beijing, 100176 (CN); Xu, Xiaohua, Beijing, 100176 (CN); Wang, Xudong, Beijing, 100176 (CN); Guo, Zheng, Beijing, 100176 (CN); Cai, Cen, Beijing, 100176 (CN)
(74) Representative: Soria Parra, Manuel

(57) **Abstract**

An embodiment of the present invention discloses a method and device for film removing process. The device includes: an optical assembly. The optical assembly includes: a laser generator for generating a laser beam; a first scanning mirror for reflecting the laser beam; a second scanning mirror for reflecting the laser beam reflected by the first scanning mirror; and a focusing mirror for focusing the laser beam reflected by the second scanning mirror onto a thin film solar cell for film removing process. The device further includes a processor and a memory in which instructions are stored, and the following steps are implemented when the instructions are executed by the processor: moving the thin film solar cell or the optical assembly to a designated position, and controlling the first scanning mirror and/or the second scanning mirror to be deflected so as to perform a film removing process on the thin film solar cell. The rate of film removing is improved and no chromatic aberrations will be generated according to the embodiments of the present invention.

## Description

### TECHNICAL FIELD

The present invention relates to the field of photovoltaic technology, and in particular to a method and a device for film removing process.

### BACKGROUND

Photovoltaic power generation is an acknowledged clean energy. In recent years, photovoltaic power generation has been strongly supported by national policies. The film-removing photovoltaic module is widely used in combination with buildings and automobiles, since it can both generate electricity and focus light, such as BIPV (Building Integrated Photovoltaic), and BAPV (Building Attached Photovoltaic). Currently, film-removing of thin film solar cells is mostly accomplished in the way of laser scribing. In other words, a laser is used to remove a proportion of the film layer whose film is not removed so as to achieve the film-removing effect; however, the conventional laser film-removing scribing is typically implemented by scribing while using a motor to drag a laser head, or by scribing in a reciprocating motion of the cell in the case that the laser beam is immobilized. These two scribing ways are both subject to the limitation of the ability of mechanical movement. In this case, the scribing speed can only reach 1000 to 2000 mm per second (mm/s), while the light spot diameter or light spot width is generally limited in a range from 50 microns (µm) to100 µm. Therefore, the rate of film removing is low. On the other hand, in the conventional laser film-removing scribing, a plurality of laser heads are used simultaneously for processing in order to improve the rate of film removing, and chromatic aberrations are likely to occur in different processing areas due to the differences in the performances of individual lasers.

### SUMMARY

According to embodiments of the present invention, there are provided a method and a device for film removing process, which can improve the efficiency of film removing process without generating chromatic aberrations.

According to an embodiment of the present invention, there is provided a device for film removing process, which includes: an optical assembly, wherein the optical assembly includes:
a laser generator for generating a laser beam;
a first scanning mirror for reflecting the laser beam;
a second scanning mirror for reflecting the laser beam reflected by the first scanning mirror; and
a focusing mirror for focusing the laser beam reflected by the second scanning mirror onto a thin film solar cell for film removing process;
wherein the device for film removing process further includes a processor and a memory in which instructions are stored, and the following steps are implemented when the instructions are executed by the processor:
moving the thin film solar cell or the optical assembly to a designated position, and controlling the first scanning mirror and/or the second scanning mirror to be deflected so as to perform a film removing process on the thin film solar cell.

Optionally, the power of the laser generator is greater than or equal to a preset power.

Optionally, the first scanning mirror and the second scanning mirror are scanning oscillating mirrors.

Optionally, a focal length of the focusing mirror is greater than or equal to a preset focal length.

Optionally, the thin film solar cell includes one or more preset areas, each of which is less than or equal to a scanning range of the first scanning mirror and the second scanning mirror.

The following steps are implemented when the instructions are executed by the processor:
moving the thin film solar cell or the optical assembly to a designated position, and controlling the first scanning mirror and/or the second scanning mirror to be deflected so as to perform a film removing process on the current preset area.

Optionally, the following steps are further implemented when the instructions are executed by the processor:
moving the thin film solar cell or the optical assembly to another designated position after the film removing process on the current preset area is completed, and controlling the first scanning mirror and/or the second scanning mirror to be deflected so as to perform a film removing process on another preset area until the film removing process is completed on all the preset areas.

According to an embodiment of the present invention, there is provided a method for film removing process, which includes:
moving a thin film solar cell or an optical assembly to a designated position; and
controlling a first scanning mirror and/or a second scanning mirror to be deflected so as to perform a film removing process on the thin film solar cell, wherein the optical assembly includes a laser generator, the first scanning mirror, the second scanning mirror and a focusing mirror, a laser beam generated by the laser generator is reflected by the first scanning mirror and the second scanning mirror, and the reflected laser beam is focused by the focusing mirror onto the thin film solar cell for film removing process.

Optionally, the method further includes:
dividing the thin film solar cell into one or more preset areas, each of which is less than or equal to a scanning range of the first scanning mirror and the second scanning mirror; and wherein
controlling a first scanning mirror and/or a second scanning mirror to be deflected so as to perform a film removing process on the current preset area includes:
controlling the first scanning mirror and/or the second scanning mirror to be deflected so as to perform a film removing process on the thin film solar cell.

Optionally, the method further includes:
moving the thin film solar cell or the optical assembly to another designated position after the film removing process is completed on the current preset area, and controlling the first scanning mirror and/or the second scanning mirror to be deflected so as to perform a film removing process on another preset area until the film removing process is completed on all the preset areas.

As compared with the related art, the device according to the embodiment of the present invention includes: an optical assembly, wherein the optical assembly includes: a laser generator for generating a laser beam; a second scanning mirror for reflecting the laser beam reflected by a first scanning mirror; the first scanning mirror for reflecting the laser beam; and a focusing mirror for focusing the laser beam reflected by the second scanning mirror onto a thin film solar cell for film removing process. The thin film solar cell includes one or more preset areas, each of which is less than or equal to a scanning range of the first scanning mirror and the second scanning mirror. The device for film removing process further includes a processor and a memory in which instructions are stored, and the following steps are implemented when the instructions are executed by the processor: moving the thin film solar cell or the optical assembly to a designated position, and controlling the first scanning mirror and/or the second scanning mirror to be deflected so as to perform a film removing process on the current preset area. According to the embodiment of the present invention, a pair of scanning mirrors is used to perform a scanning-type film removing process on the thin film solar cell, thus increasing the one-time processing area and improving the rate of film removing. Moreover, the rate of film removing can be increased using a single laser generator and no chromatic aberration is generated.

In an alternative embodiment, a laser generator having a power greater than or equal to a preset power is used for film removing process, therefore the light spot size of the laser beam is increased, and the rate of film removing is further improved.

Additional features and advantages of the invention will be set forth in the following description, which in part become apparent from the description or may be learned through the practice of the invention. The objects and other advantages of the invention may be realized and obtained through the structures particularly mentioned in the specification, claims as well as the accompanying drawings.

### BRIEF DESCRIPTION OF THE DRAWINGS

The accompanying drawings are used to provide a further understanding of the technical solutions of the present invention, and constitute a part of the specification. In conjunction with the embodiments of the present invention, the drawings are used to explain the technical solutions of the present invention, but are not intended to limit the technical solutions of the present invention.
Fig.1 is a schematic structural view of a thin film solar cell according to an embodiment of the present invention;
Fig.2 is a schematic view of a conventional method for film removing process;
Fig.3 is a schematic structural view of a device for film removing process according to an embodiment of the present invention;
Fig.4 is a schematic view of a thin film solar cell according to an embodiment of the present invention; and
Fig.5 is a flow chart of a method for film removing process according to an embodiment of the present invention.

### DETAILED DESCRIPTION

Hereinafter, embodiments of the present invention are described in detail with reference to the accompanying drawings. It should be noted that the embodiments and features in the embodiments of the present invention can be combined with each other in any form where no conflicts will be caused.

Steps illustrated in the flow chart of the drawing may be executed in a computer system including such as a set of computer-executable instructions. Moreover, although a logical order is shown in the flow chart, the illustrated or described steps may be performed in some situations in an order other than the order described herein.

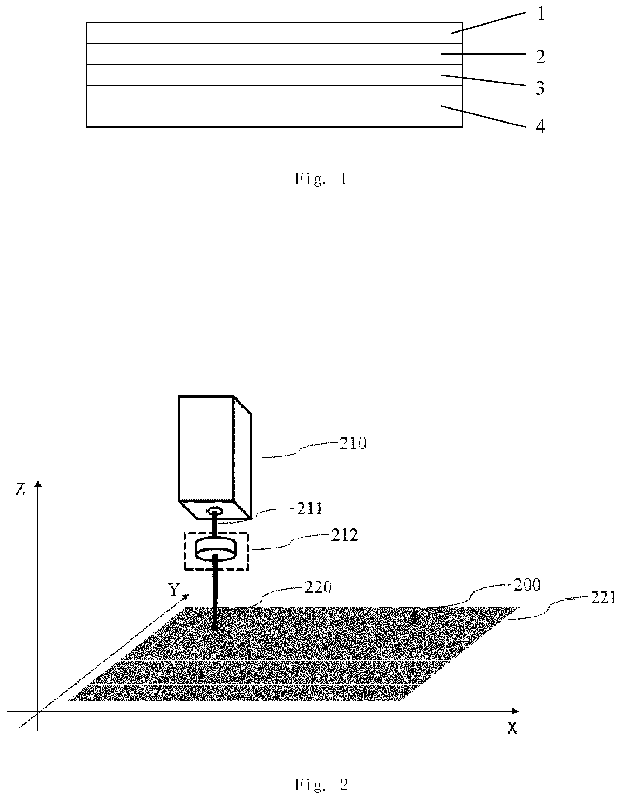

Before the method for film removing process according to an embodiment of the present invention is set forth, the structure of the thin film solar cell employing the method is introduced firstly. Fig. 1 is a schematic structural view of a thin film solar cell according to an embodiment of the present invention. As shown in Fig. 1, the thin film solar cell includes a back electrode layer 1, a photovoltaic film layer 2, a front electrode layer 3, and a transparent substrate 4 from top to bottom. A typical method for film removing process is to selectively etch and remove the back electrode layer 1 and the photovoltaic film layer 2, or the back electrode layer 1, the photovoltaic film layer 2 and the front electrode layer 3, by using a laser.

The conventional method for film removing process is shown in Fig.2. Cell structure scribed lines 221 parallel with the X axis are already present on a thin film solar cell 200, and the cell structure scribed lines 221 are inherent scribed lines on the thin film solar cell 200, which are not required to be obtained by performing a film removing process using a laser generator 210.

The film-removing scribed lines 220 parallel with the Y axis on the thin film solar cell 200 are required to be obtained by performing a film removing process using the laser generator 210. The specific method for film removing process is described substantially as follows.

The laser generator 210 is fixed at a position on the Z axis, and a laser beam 211 generated by the laser generator 210 emits light in a fixed direction through a focusing mirror 212. The thin film solar cell 200 is gripped on a platform which is parallel with the XOY plane. Through a Y axis mechanical movement, the platform can drag the thin film solar cell 200 to move along a direction parallel with the Y axis, thereby generating a film-removing scribed line 220 parallel with the Y axis. After a complete film-removing scribed line 220 parallel with the Y axis is generated, if another film-removing scribed line 220 parallel with the Y axis is required to be generated, the platform has to drag the thin film solar cell 200 to step through a X axis mechanical movement, thereby generating another film-removing scribed line 220 parallel with the Y axis.

The conventional method for film removing process is limited by the mechanical movement, and the scribing speed can only be in a range from 1000 to 2000 mm/s. Meanwhile, the diameter or width of the light spot is generally limited in a range from about 50 µm to 100 µm. Therefore, the rate of film removing is low. On the other hand, in the conventional laser film-removing scribing, a plurality of laser heads are used simultaneously for processing in order to improve the rate of film removing, and chromatic aberrations are likely to occur in different processing areas due to the differences in the performances of individual lasers.

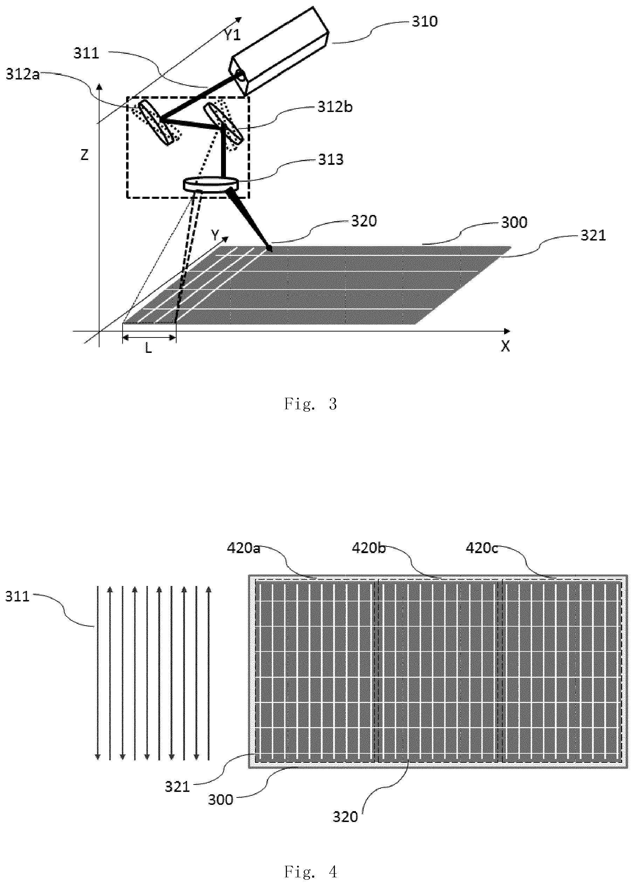

Referring to Fig.3, according to an embodiment of the present invention, there is provided a device for film removing process, which includes: an optical assembly,
wherein the optical assembly includes:
a laser generator 310 for generating a laser beam;
a first scanning mirror 312a for reflecting the laser beam;
a second scanning mirror 312b for reflecting the laser beam reflected by the first scanning mirror 312a; and
a focusing mirror 313 for focusing the laser beam reflected by the second scanning mirror 312b onto a thin film solar cell 300 for film removing process.

In an alternative embodiment, the power of the laser generator 310 is greater than or equal to a preset power. For example, the power of the laser generator 310 is in a range from several ten Watts to several hundred Watts. For example, a green laser generator having a power of 100 W and a wavelength of 532 nanometers (nm) is used.

A high-power laser generator is used for film removing process, and therefore the light spot size of the laser beam is increased, thus further improving the rate of film removing.

In an alternative embodiment, the first scanning mirror 312a and the second scanning mirror 312b are scanning oscillating mirrors.

In an alternative embodiment, the focal length of the focusing mirror 313 is greater than or equal to a preset focal length. For example, the focusing mirror 313 has a focal length of 825 millimeters (mm), such as a model F825 focusing mirror.

The device for film removing process describe above further includes a processor and a memory in which instructions are stored, and the following steps are implemented when the instructions are executed by the processor:
moving the thin film solar cell or the optical assembly to a designated position, and controlling the first scanning mirror and/or the second scanning mirror to be deflected so as to perform a film removing process on the solar cell 300.

Since the first scanning mirror 312a and the second scanning mirror 312b each have a certain scanning range, the processing area at each time cannot be greater than the scanning range when the film removing process is performed. Therefore, in a case that the size of the thin film solar cell 300 is less than or equal to the scanning range of the first scanning mirror 312a and the second scanning mirror 312b, there is no need to divide the thin film solar cell 300. In a case that the size of the thin film solar cell 300 is greater than the scanning range of the first scanning mirror 312a and the second scanning mirror 312b, the thin film solar cell 300 needs to be divided into two or more preset areas, and then the film removing process is separately performed on each of the preset areas. That is, the first preset area is subject to the film removing process; after completion, the second preset area is subject to the film removing process; after completion, the third preset area is subject to the film removing process, ... , and so on, until the film removing process is completed on all the preset areas.

The method for film removing process on each preset area is described in detail below.

Firstly, in a case that the film removing process is performed on the solar cell 300, a pattern for removing a film may be any pattern. For example, the pattern for removing a film may be a spot, a scribed line, or other patterns, which is not limited in the embodiments of the present invention.

The case where the pattern for removing a film is a scribed line is described as an example below.

Forming a scribed line during the movement of the laser beam 311 needs to satisfy that the overlapping ratio between any two adjacent light spots is greater than or equal to a preset threshold. If the overlapping ratio between two adjacent light spots is less than the preset threshold, two independent light spots are obtained.

When the thin film solar cell or the optical assembly is moved to the designated position, the designated position should at least enable the control of the deflection of the first scanning mirror and/or the second scanning mirror to complete the film removing process on the current preset area. The designated position may be any position as long as the film removing process on the current preset area can be completed. For example, in Fig.3, if the film-removing scribed line 320 parallel with the Y axis needs to be obtained, the first scanning mirror 312a and the second scanning mirror 312b may be firstly adjusted to the zero position, and then the thin film solar cell or the optical assembly is moved to the designated position so that the laser beam is focused onto the upper left corner of the preset area. Then, the first scanning mirror 312a and the second scanning mirror 312b are controlled to be deflected.

As shown in Fig. 4, it is assumed that the thin film solar cell includes three preset areas, i.e., a preset area 420a, a preset area 420b, and a preset area 420c respectively. Ten film-removing scribed lines 320 parallel with the Y axis now need to be scribed in each of the preset area 420a, the preset area 420b and the preset area 420c. The first scanning mirror 312a and the second scanning mirror 312b are firstly adjusted to the zero position, and then the thin film solar cell or the optical assembly is moved to the designated position so that the laser beam is focused onto the upper end of the first film-removing scribed line 320 in the preset area 420a, then the first scanning mirror 312a is controlled to remain stationary and the second scanning mirror 312b is controlled to be deflected so that the laser beam is gradually moved from the upper end to the lower end of the first film-removing scribed line 320 to complete the film removing process on the first film-removing scribed line 320. After that, the laser generator 310 is turned off, then the second scanning mirror 312b is controlled to remain stationary and the first scanning mirror 312a is controlled to be deflected so that the laser beam is moved to the lower end of the second film-removing scribed line 320. Then, the laser generator 310 is turned on, and the first scanning mirror 312a is controlled to remain stationary and the second scanning mirror 312b is controlled to be deflected so that the laser beam is gradually moved from the lower end to the upper end of the second film-removing scribed line 320 to complete the film removing process on the second film-removing scribed line 320. By analogy, the film removing process on ten film-removing scribed lines 320 in the preset area 420a is completed.

In an alternative embodiment, the following steps are implemented when the instructions are executed by the processor:
moving the thin film solar cell or the optical assembly to a designated position, and controlling the first scanning mirror and/or the second scanning mirror to be deflected to perform a film removing process on the current area.

In an alternative embodiment, the following steps are implemented when the instructions are executed by the processor:
moving the thin film solar cell or the optical assembly to another designated position after the film removing process on the current preset area is completed, and controlling the first scanning mirror and/or the second scanning mirror to be deflected so as to perform a film removing process on another preset area until the film removing process is completed on all the preset areas.

According to the embodiment of the present invention, a pair of scanning mirrors is used to perform a scanning-type film removing process on the thin film solar cell, thus increasing the one-time processing area and improving the rate of film removing. Moreover, the rate of film removing can be increased using a single laser generator and no chromatic aberration is generated.

For example, when the scanning range of the first scanning mirror 312a and the second scanning mirror 312b is from 0×0 mm to 1500×1500 mm, the scribing speed is 15000 mm/s, and the width or diameter of the light spot is 1 mm in film removing process, the rate of film removing can be up to 15,000 square millimeters per second (mm²/s). In the conventional method for film removing process, when the diameter of the light spot is 100 µm and the scribing speed is 1500 mm/s, the rate of film removing is 150 mm²/s. Therefore, the method for film removing process according to the embodiment of the present invention is 100 times faster than the conventional method for film removing process.

In addition, patterns, texts and points marking according to an arbitrary figure are realized using the first scanning mirror 312a and the second scanning mirror 312b, and patterns, texts and so on are formed on the thin film solar cell 300, which is difficult to achieve in the conventional method for film removing process.

Finally, due to a fast rate of film removing when a high-power laser generator is used, scribing of lines and removing of the film can be performed quickly by using a single laser head without causing the chromatic aberration problem.

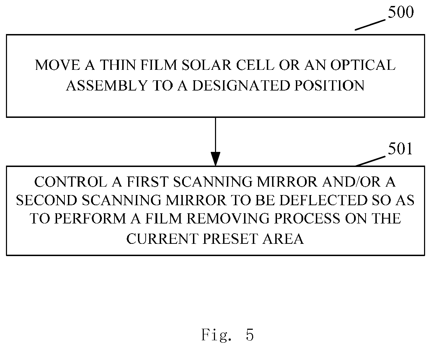

Referring to Fig.5, a method for film removing process is provided according to an embodiment of the present invention. Since the first scanning mirror 312a and the second scanning mirror 312b each have a certain scanning range, the processing area at each time cannot be greater than the scanning range when the film removing process is performed. Therefore, in a case that the size of the thin film solar cell 300 is less than or equal to the scanning range of the first scanning mirror 312a and the second scanning mirror 312b, there is no need to divide the thin film solar cell 300. In a case that the size of the thin film solar cell 300 is greater than the scanning range of the first scanning mirror 312a and the second scanning mirror 312b, the thin film solar cell 300 needs to be divided into two or more preset areas, and then the film removing process is separately performed on each of the preset areas. That is, the first preset area is subject to the film removing process; after completion, the second preset area is subject to the film removing process; after completion, the third preset area is subject to the film removing process, ... , and so on, until the film removing process is completed on all the preset areas.

The method includes the following steps 500 to 501.

In step 500, a thin film solar cell or an optical assembly is moved to a designated position.

In this embodiment, the optical assembly includes a laser generator, a first scanning mirror, a second scanning mirror and a focusing mirror, the laser beam generated by the laser generator is reflected by the first scanning mirror and the second scanning mirror, and the reflected laser beam is focused by the focusing mirror onto the thin film solar cell for film removing process.

When the thin film solar cell or the optical assembly is moved to the designated position, the designated position should at least enable the control of the deflection of the first scanning mirror and/or the second scanning mirror to complete the film removing process on the current preset area. The designated position may be any position as long as the film removing process on the current preset area can be completed. For example, in Fig.3, if the film-removing scribed line 320 parallel with the Y axis needs to be obtained, the first scanning mirror 312a and the second scanning mirror 312b may be firstly adjusted to the zero position, and then the thin film solar cell or the optical assembly is moved to the designated position so that the laser beam is focused onto the upper left corner of the preset area. Then, the first scanning mirror 312a and the second scanning mirror 312b are controlled to be deflected.

In step 501, the first scanning mirror and/or the second scanning mirror is controlled to be deflected to perform a film removing process on the current preset area.

The method for film removing process on each preset area is described in detail below.

Firstly, in a case that the film removing process is performed on the solar cell 300, a pattern for removing a film may be any pattern. For example, the pattern for removing a film may be a spot, a scribed line, or other patterns, which is not limited in the embodiments of the present invention.

The case where the pattern for removing a film is a scribed line is described as an example below.

Forming a scribed line during the movement of the laser beam 311 needs to satisfy that the overlapping ratio between any two adjacent light spots is greater than or equal to a preset threshold. If the overlapping ratio between two adjacent light spots is less than the preset threshold, two independent light spots are obtained.

As shown in Fig. 4, it is assumed that the thin film solar cell includes three preset areas, i.e., a preset area 420a, a preset area 420b, and a preset area 420c respectively. Ten film-removing scribed lines 320 parallel with the Y axis now need to be scribed in each of the preset area 420a, the preset area 420b and the preset area 420c. The first scanning mirror 312a and the second scanning mirror 312b are firstly adjusted to the zero position, and then the thin film solar cell or the optical assembly is moved to the designated position so that the laser beam is focused onto the upper end of the first film-removing scribed line 320 in the preset area 420a, then the first scanning mirror 312a is controlled to remain stationary and the second scanning mirror 312b is controlled to be deflected so that the laser beam is gradually moved from the upper end to the lower end of the first film-removing scribed line 320 to complete the film removing process on the first film-removing scribed line 320. After that, the laser generator 310 is turned off, then the second scanning mirror 312b is controlled to remain stationary and the first scanning mirror 312a is controlled to be deflected so that the laser beam is moved to the lower end of the second film-removing scribed line 320. Then, the laser generator 310 is turned on, and the first scanning mirror 312a is controlled to remain stationary and the second scanning mirror 312b is controlled to be deflected so that the laser beam is gradually moved from the lower end to the upper end of the second film-removing scribed line 320 to complete the film removing process on the second film-removing scribed line 320. By analogy, the film removing process on ten film-removing scribed lines 320 in the preset area 420a is completed.

In an alternative embodiment, controlling the first scanning mirror and/or the second scanning mirror to be deflected so as to perform a film removing process on the thin film solar cell includes: controlling the first scanning mirror and/or the second scanning mirror to be deflected so as to perform a film removing process on the current area.

In an alternative embodiment, the method further includes:
moving the thin film solar cell or the optical assembly to another designated position after the film removing process on the current preset area is completed, and controlling the first scanning mirror and/or the second scanning mirror to be deflected so as to perform a film removing process on another preset area until the film removing process is completed on all the preset areas.

According to the embodiments of the present invention, a pair of scanning mirrors is used to perform the scan-type film removing process on the thin film solar cell, thus increasing the one-time processing area and improving the rate of film removing. Moreover, the rate of film removing can be increased using a single laser generator and no chromatic aberrations is generated.

For example, when the scanning range of the first scanning mirror 312a and the second scanning mirror 312b is from 0×0 mm to 1500×1500 mm, the scribing speed is 15000 mm/s, and the width or diameter of the light spot is 1 mm in film removing process, the rate of film removing can be up to 15,000 square millimeters per second (mm²/s). In the conventional method for film removing process, when the diameter of the light spot is 100 µm and the scribing speed is 1500 mm/s, the rate of film removing is 150 mm²/s. Therefore, the method for film removing process according to the embodiment of the present invention is 100 times faster than the conventional method for film removing process.

In addition, patterns, texts and points marking according to an arbitrary pattern are realized using the first scanning mirror 312a and the second scanning mirror 312b, and the patterns, texts and so on are formed on the thin film solar cell 300, which is difficult to achieve in the conventional method for film removing process.

Finally, due to a fast rate of film removing when a high-power laser generator is used, scribing of lines and removing of the film can be performed quickly by using a single laser head without causing the chromatic aberration problem.

While the embodiments of the invention are disclosed above, the invention is only the embodiments adopted for understanding the invention, and is not intended to limit the invention. Various modifications and alternations on the forms and details of implementation may be made by those skilled in the art without departing from the scope of the invention. Nevertheless, the scope of protection of the invention should still be defined by the scope of the appended claims.

## Claims

1. A device for film removing process, comprising an optical assembly,
wherein the optical assembly comprises:
a laser generator (310) for generating a laser beam;
a first scanning mirror (312a) for reflecting the laser beam;
a second scanning mirror (312b) for reflecting the laser beam reflected by the first scanning mirror; and
a focusing mirror (313) for focusing the laser beam reflected by the second scanning mirror onto a thin film solar cell for film removing process;
wherein the device for film removing process further comprises a processor and a memory in which instructions are stored, and the following steps are implemented when the instructions are executed by the processor:
moving the thin film solar cell or the optical assembly to a designated position, and controlling the first scanning mirror (312a) and/or the second scanning mirror (312b) to be deflected so as to perform a film removing process on the thin film solar cell (300).

2. The device for film removing process of claim 1, wherein the power of the laser generator (310) is greater than or equal to a preset power.

3. The device for film removing process of claim 1, wherein the first scanning mirror (312a) and the second scanning mirror (312b) are scanning oscillating mirrors.

4. The device for film removing process of claim 1, wherein a focal length of the focusing mirror (313) is greater than or equal to a preset focal length.

5. The device for film removing process of claim 1, wherein the thin film solar cell (300) comprises one or more preset areas, each of which is less than or equal to a scanning range of the first scanning mirror and the second scanning mirror;
the following steps are implemented when the instructions are executed by the processor:
moving the thin film solar cell or the optical assembly to a designated position, and controlling the first scanning mirror (312a) and/or the second scanning mirror (312b) to be deflected so as to perform a film removing process on the current preset area.

6. The device for film removing process of claim 5, wherein the following steps are further implemented when the instructions are executed by the processor:
moving the thin film solar cell (300) or the optical assembly to another designated position after the film removing process on the current preset area is completed, and controlling the first scanning mirror (312a) and/or the second scanning mirror (312b) to be deflected so as to perform a film removing process on another preset area until the film removing process is completed on all the preset areas.

7. A method for film removing process, comprising:
moving (500) a thin film solar cell or an optical assembly to a designated position; and
controlling (501) a first scanning mirror and/or a second scanning mirror to be deflected so as to perform a film removing process on the thin film solar cell, wherein the optical assembly comprises a laser generator, the first scanning mirror, the second scanning mirror and a focusing mirror, a laser beam generated by the laser generator is reflected by the first scanning mirror and the second scanning mirror, and the reflected laser beam is focused by the focusing mirror onto the thin film solar cell for film removing process.

8. The method for film removing process of claim 7, wherein the method further comprises:
dividing the thin film solar cell into one or more preset areas, each of which is less than or equal to a scanning range of the first scanning mirror and the second scanning mirror; and wherein
controlling a first scanning mirror and/or a second scanning mirror to be deflected so as to perform a film removing process on the thin film solar cell comprises:
controlling the first scanning mirror and/or the second scanning mirror to be deflected so as to perform a film removing process on the current preset area.

9. The method for film removing process of claim 8, further comprising:
moving the thin film solar cell or the optical assembly to another designated position after the film removing process is completed on the current preset area, and controlling the first scanning mirror and/or the second scanning mirror to be deflected so as to perform a film removing process on another preset area until the film removing process is completed on all the preset areas.
